Europäisches Patentamt

(19) European Patent Office

Office européen des brevets

(11) Numéro de publication: **0 074 294**
**B1**

(12) **FASCICULE DE BREVET EUROPEEN**

(45) Date de publication du fascicule du brevet:
27.03.85

(21) Numéro de dépôt: **82401515.0**

(22) Date de dépôt: **10.08.82**

(51) Int. Cl.⁴: **H 03 F 1/02,** H 03 F 3/193,
G 01 S 7/28

(54) Amplificateur hyperfréquence à transistor à effet de champ, notamment pour radar Doppler.

(30) Priorité: **25.08.81 FR 8116215**

(43) Date de publication de la demande:
**16.03.83 Bulletin 83/11**

(45) Mention de la délivrance du brevet:
**27.03.85 Bulletin 85/13**

(84) Etats contractants désignés:
**CH DE GB IT LI NL SE**

(56) Documents cités:
FR - A - 2 425 175
FR - A - 2 448 254

**CONFERENCE PROCEEDINGS, 9th EUROPEAN
MICROWAVE CONFERENCE, 17th-20th septembre
1979, pages 293-297, Brighton Centre, England
Microwave Exhibitions and Publishers Ltd., Kent (GB);
R.S. PENGELLY et al.: "Prematched and monolithic
amplifiers covering 8-18 GHz".**

(73) Titulaire: **LMT RADIO PROFESSIONNELLE, 46-47, Quai
Alphonse Le Gallo, F-92103 Boulogne-Billancourt (FR)**

(72) Inventeur: **Marchand, Maurice, THOMSON-CSF
SCPI 173 Boulevard Haussmann, F-75379 Paris
Cedex 08 (FR)**
Inventeur: **Haentjens, Yan, THOMSON-CSF
SCPI 173 Boulevard Haussmann, F-75379 Paris
Cedex 08 (FR)**

(74) Mandataire: **Desperrier, Jean-Louis et al,
THOMSON-CSF SCPI 173, Bld Haussmann,
F-75379 Paris Cedex 08 (FR)**

## Description

La présente invention se rapporte aux amplificateurs hyperfréquence à transistors à effet de champ qui permettent d'amplifier une onde hyperfréquence sans utiliser de tube à vide. Ces amplificateurs hyperfréquence sont notamment utilisés dans les radars du type Doppler, et plus particulièrement dans ceux qui sont destinés à la surveillance terrestre, pour lesquels on cherche à éliminer les tubes à vide en vue de réduire le poids, l'encombrement, et la consommation.

Il est connu d'un article de R. S. Pengelly et al, paru dans »CONFERENCE PROCEEDINGS, 9th EUROPEAN MICROWAVE CONFERENCE, 17th — 20th september 1979«, pages 293—297, sous le titre »PREMATCHED AND MONOLITHIC AMPLIFIERS COVERING 8—18 GHz«, d'utiliser des transistors à effet de champ à l'arséniure de gallium pour amplifier des hyperfréquences dans la bande dite I, qui se situe aux alentours de 10 GHz. Ces transistors comprennent des moyens d'adaptation et des moyens de polarisation intégrés dans un même boitier, ce qui permet de faciliter la fabrication des amplificateurs. Ils ne peuvent toutefois fonctionner qu'en classe A, ce qui entraine une consommation constante et assez importante. L'économie de consommation, que l'on pouvait espérer en utilisant les transistors à la place des tubes à vide, se trouve ainsi fortement diminuée, puisque ces derniers sont susceptibles de fonctionner en classe C, avec une consommation moyenne donc bien plus faible compte tenu, d'une part du rendement intrinsèque de la classe C par rapport à la classe A, et d'autre part d'un taux de remplissage généralement faible lorsqu'ils sont utilisés en impulsions (cas des radars).

Il est également connu de la demande de brevet français n° 2 448 254 d'alimenter le transistor d'un amplificateur haute fréquence à l'aide d'une source de courant régulée. En commandant cette source par des créneaux qui encadrent les impulsions haute fréquence appliquées au transistor, on diminue la consommation à vide de l'amplificateur. Le transistor utilisé est un transistor à jonctions monté avec la base à la masse, ce qui est nécessaire en haute fréquence. Il est donc attaqué par son émetteur et c'est également sur celui-ci qu'est connectée la source de courant régulée. Le collecteur, sur lequel on sort le signal amplifié, est alimenté par une source de tension non décrite mais qui n'est pas régulée puisque l'on utilise un condensateur de forte capacité pour fournir les impulsions de courant nécessaire pendant les instants de fonctionnement du transistor.

On ne pourrait donc pas utiliser ces moyens d'alimentation avec un transistor à effet de champ tel que décrit plus haut puisque celui-ci est attaqué par sa grille, ce qui réalise l'équivalent d'un montage en émetteur commun pour un transistor à jonctions. La source est alors à la masse et le drain doit être attaqué par une source de tension et non de courant.

Selon l'invention on utilise un régulateur de tension pour alimenter le drain du transistor. L'amplificateur comprend en outre un circuit de commande qui permet d'amplifier un signal analogique de commande et de l'appliquer sur une première entrée de ce récepteur afin de faire varier la tension régulée fournie par celui ci. On peut ainsi faire varier le gain de l'amplificateur tout en conservant un taux d'ondes stationnaires sensiblement constant. Ce circuit de commande fourni également sur une deuxième entrée du régulateur la tension de référence nécessaire à celui-ci et permet à partir d'un signal numérique de commande de moduler par tout ou rien cette tension de référence, ce qui entraine la coupoure de la tension d'alimentation selon la modulation de ce signal de référence et donc du signal numérique.

D'autres particularités et avantages de l'invention apparaîtront clairement dans la description suivante présentée à titre d'exemple non limitatif et faite en regard de la figure annexée qui représente le schéma d'un amplificateur selon l'invention.

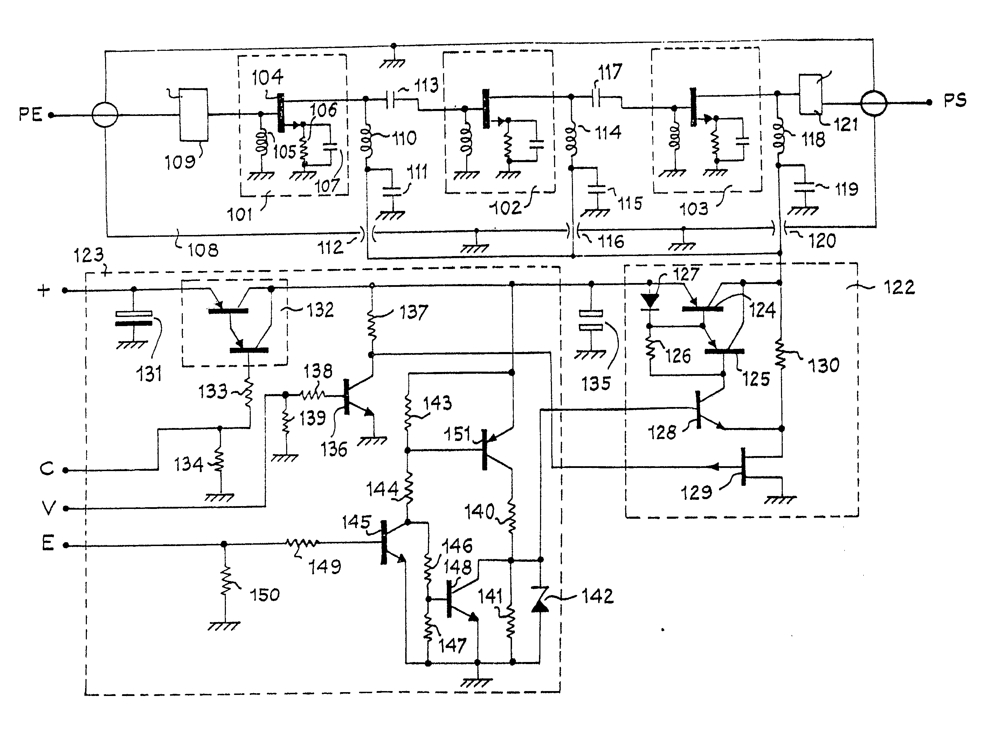

L'amplificateur hyperfréquence dont le schéma est représenté sur la figure 1, utilise comme composants actifs hyperfréquence trois transistors à effet de champ 101 à 103. Ces transistors sont connus dans le commerce sous la référence THC 9311-9312, et comportent en fait dans un boîtier un transistor à l'arséniure de galium tel que 104, qui est muni d'éléments permettant une préadaptation et une autopolarisation. Ces éléments comportent une inductance de choc 105 qui relie la grille du transistor à la masse au point de vue continu, et une résistance de polarisation 106 qui relie la source à la masse et qui est shuntée par un condensateur de découplage 107. Ces éléments, ainsi que les conducteurs reliant le transistor aux bornes de sortie du boîtier dans lequel il est livré, permettent un montage très simple, puisqu'il ne nécessite aucun élément externe de polarisation, et un minimum d'éléments externes d'adaptation aux circuits dans lesquels il est monté.

Ces trois transistors sont montés dans une structure hyperfréquence 108, formée selon une technique connue par un bloc métallique dans lequel sont creusées des cavités recevant les différents organes, en isolant les étages entre eux pour ne permettre la liaison que par des connexions traversant les parois situées entre ces cavités par des orifices adéquats.

Le premier étage d'amplification 101 est attaqué par un signal d'entrée PE qui est appliqué sur la grille du premier transistor 101 par un circuit d'adaptation 109, qui n'est pas représenté en détail sur la figure car il comporte essentiellement, de manière connue dans l'art, un transformateur d'impédance permettant d'adapter l'impédance relativement faible de la grille du transistor à celle, plus importante, des circuits extérieurs qui attaquent le transistor, et dont la valeur est, se

lon une pratique courante en hyperfréquence, par exemple de 50 ohms.

La résistance 106 de source du transistor 101 est reliée à la masse de la structure 108, et son drain est alimenté en courant continu par l'intermédiaire d'une inductance de charge 110 découplée à la masse par un condensateur de découplage 111 et par un condensateur de by-pass 112. L'inductance 110 est représentée pous les besoins du dessin sous la forme d'une bobine mais, compte tenu des fréquences utilisées, elle est bien entendu sous la forme d'une ligne à constante répartie, ainsi que les autres inductances du circuit.

La sortie de ce premier étage est prise sur le drain du transistor 101, et est reliée à la grille du transistor 102 par l'intermédiaire d'un condensateur de liaison 113.

Ce deuxième étage est connecté, de la même manière que le premier, par une inductance de charge 114, un condensateur de découplage 115, et un condensateur de by-pass 116. Il est relié au troisième étage par un condensateur de liaison 117.

Ce troisième étage est lui-même alimenté par une inductance de charge 118, un condensateur de découplage 119 et un condensateur de by-pass 120.

La sortie de l'amplificateur hyperfréquence est prise sur le drain du transistor 103 par l'intermédiaire d'un circuit d'adaptation 121 non précisé sur le dessin pour la simplicité, mais d'une technique courante en hyperfréquence comme le circuit 109. Ce circuit d'adaptation délivre un signal de sortie PS.

Pour alimenter les trois étages d'amplification hyperfréquence, l'invention propose d'utiliser un régulateur de tension 122 lui-même commandé par un circuit de commande 123.

Le régulateur comporte un transistor ballast 124 dont l'émetteur reçoit une tension d'alimentation positive d'environ 10 volts du circuit de commande 123, et dont le collecteur délivre la tension d'alimentation régulée aux trois impédances de charge 110, 114 et 118.

Le transistor 124 est connecté selon le montage Darlington à l'aide d'un transistor 125 dont l'émetteur est réuni à la base par une résistance 126.

L'émetteur du transistor 124 est réuni à sa propre base par une diode de polarisation 127.

La base du transistor 125 est reliée également au collecteur d'un transistor 128, dont l'émetteur est relié à la masse par l'intermédiaire du circuit drain-source d'un transistor à effet de champ 129.

La base du transistor 128 reçoit une tension de référence, et la grille du transistor 129 une tension de commande.

L'émetteur du transistor 128 est également réuni au collecteur du transistor 124 par une résistance 130.

Le montage ainsi réalisé constitue un régulateur relativement classique, mais dont la tension de sortie est réglable en agissant par la tension de commande appliquée sur la grille du transistor 129, qui agit en résistance variable. D'autre part on peut, en supprimant ou en établissant la tension de référence, couper ou établir la tension de sortie du régulateur dans un délai extrêmement rapide qui ne dépasse pas quelques dizaines de nanosecondes, si la vitesse de coupure ou d'établissement de cette tension de référence est suffisante bien entendu.

Le circuit de commande comporte un condensateur de filtrage 131 qui est alimenté par la tension d'alimentation. Ce condensateur de filtrage est relié à l'entrée d'alimentation du régulateur 122 par l'intermédiaire d'un transistor 132 du type Darlington intégré. La base du transistor 132 est reliée à la masse par des résistances 133 et 134 en série.

Le point commun de ces deux résistances est réuni à une connexion d'entrée du circuit de commande qui peut recevoir un signal de coupure C lequel permet de bloquer le transistor 132, et par là même de couper l'alimentation de l'amplificateur hyperfréquence lors de la détection d'un défaut, par exemple à l'aide d'un circuit extérieur.

La connexion d'alimentation entre les circuits 122 et 123 est d'autre part shuntée à la masse par un condensateur 135, qui permet de filtrer la tension de sortie du circuit 123.

Le circuit de commande 123 comprend également un transistor 136 alimenté à partir de la sortie du transistor 132 par une résistance 137 reliée à son collecteur. Son émetteur et sa base sont reliés à la masse, directement pour l'émetteur, et par l'intermédiaire de deux résistances 138 et 139 en série pour la base.

Le point commun de ces deux résistances 138 et 139 est relié à une connexion d'entrée du circuit de commande 123, qui peut recevoir un signal de commande analogique V. Ce signal est donc amplifié par le transistor 136 et se retrouve avec la phase inverse et un niveau adéquat sur le collecteur de ce dernier. Il est alors appliqué depuis ce collecteur à la grille du transistor à effet de champ 129 du régulateur 122. La résistance présentée par le circuit drain-source de ce transistor 129 varie donc en fonction des variations du signal de commande V. Ceci permet de faire varie la tension d'alimentation des étages d'amplification hyperfréquence de l'amplificateur selon les variations de ce signal V.

Les inventeurs ont en effet constaté que dans un tel montage, utilisant notamment les tranistors hyperfréquences cités plus haut, le taux d'onde stationnaire de l'ensemble variait très peu avec la tension d'alimentation alors que le gain variait d'une façon très significative.

Ceci permet de moduler le signal PS en sortie de l'amplificateur de façon tout à fait simple et pratiquement sans désadapter cet amplificateur.

On a pu ainsi faire varier le gain de 10 décibels, ce qui correspond à une modulation d'amplitude de 30%, en gardant un taux d'onde stationnaire compris entre 1,5 et 2. La bande de fréquence dans lequel ce résultat a pu être obtenu s'étendait de 9,3 à 9,9 GHz et le gain total maximum était de 23 décibels à 9,6 GHz permettant d'obtenir, avec une consommation de 100 milliampères, et un signal PE suffisant à l'entrée, un niveau de sortie de +14 décibels-milliwatts.

Le signal de coupure C permet de supprimer l'alimentation totale du dispositif, en cas par exemple de détection d'un mauvais fonctionnement. La rapidité de cette coupure n'est pas très grande, en raison notamment du condensateur de filtrage 135. Pour pouvoir alors moduler l'amplificateur par tout ou rien, et le faire fonctionner en impulsions alors que la modulation due au signal V conservait le fonctionnement en ondes entretenues, le circuit de commande comprend en outre des moyens permettant d'appliquer sur la base du transistor 128 une tension de référence pouvant être coupée à partir d'un signal de commande numérique E.

Ces moyens comprennent un transistor 151 dont l'émetteur est alimenté à partir du collecteur du transistor 132 et dont le collecteur est relié à la masse par deux résistances 140 et 141 en série. La résistance 141 est shuntée par une diode Zener 142 qui fournit une tension stabilisée de référence à la base du transistor 128.

La base du transistor 151 est reliée à son émetteur par une résistance 143 et au collecteur d'un transistor 145 par une résistance 144.

L'émetteur et le collecteur du transistor 145 sont reliés à la masse, le premier directement, et le second par deux résistances 146 et 147 en série. La connexion commune à ces deux résistances est reliée à la base d'un transistor 148 dont l'émetteur est à la masse et le collecteur à la cathode de la diode 142.

La base du transistor 145 est reliée à la masse par deux résistances 149 et 150 en série.

Le signal numérique de commande E est appliqué à une borne d'entrée du circuit 123 qui est reliée au point commun aux résistances 149 et 150.

Ainsi un signal numérique de commande, compatible par exemple avec des circuits TTL, appliqué sur cette entrée E, fait varier la tension de référence appliquée au régulateur 122 entre une valeur nulle et la valeur de référence proprement dite en reproduisant les variations de ce signal numérique. L'amplificateur hyperfréquence fonctionne ainsi en impulsions, mais le signal à l'intérieur de ces impulsions demeure en classe A. Dans l'exemple numérique cité plus haut, on obtient un temps de montée et de descente des impulsions hyperfréquences inférieur à 100 nanosecondes.

L'amplificateur hyperfréquence ainsi décrit peut être utilisé par exemple dans un radar Doppler de surveillance terrestre comme préamplificateur avant l'émetteur de puissance. Dans ce cas on peut utiliser trois moyens de modulation combinables entre eux selon les résultats voulus.

Le premier moyen de modulation consiste à appliquer comme signal hyperfréquence PE à amplifier un signal formé d'impulsions avec un taux de remplissage quelconque. Quand ce taux de remplissage est de 100%, il est clair que l'on a à ce moment là un signal entretenu pur.

Le deuxième moyen de modulation consiste à appliquer un signal numérique sur l'entrée E du circuit de commande. Ceci permet par exemple de réduire la consommation de l'amplificateur, lorsque le signal PE est formé d'impulsions, en encadrant ces impulsions à l'aide du signal E, ce qui coupe l'alimentation, et donc le débit des transistors 101 à 103, en dehors des impulsions hyperfréquence désirées.

Le troisième moyen de modulation consiste à appliquer sur l'entrée V un signal analogique, qui peut être par exemple une modulation de parole. Cette modulation se superpose par exemple à la modulation du radar et peut permettre alors une transmission vocale vers d'autres radars situés dans la même zone de surveillance, ou vers des récepteurs portés par des véhicules spécialement équipés.

Le signal V peut également correspondre à un signal de commande automatique de gain obtenu à partir d'une mesure du niveau du signal émis par le radar. Une autre application d'un tel signal de CAG consiste à utiliser l'amplificateur comme émetteur multicanaux de faible puissance. En utilisant le signal de CAG in régularise la bande passante, et il est par exemple possible avec 10 décibels de commande de gain d'avoir un émetteur pouvant fonctionner dans une bande de 600 MHz centrée à 9,6 GHz.

**Revendications**

1. Amplificateur hyperfréquence comportant au moins un transistor d'amplification hyperfréquence (104) à effet de champ recevant sur sa grille un signal à amplifier et délivrant sur son drain le signal amplifié, ce transistor étant muni de moyens d'adaption (105) et de polarisation (106, 107) formant avec lui un composant unitaire (101) préadapté et autopolarisé, cet amplificateur comportant également un régulateur d'alimentation (122) du circuit drain source du transistor, caractérisé en ce que ce régulateur (122) permet d'alimenter le drain du transistor (101) avec une tension régulée variable, et que l'amplificateur comprend en outre un circuit de commande (123) comportant des moyens d'amplification (136—139) permettant d'amplifier un signal analogique de commande et de l'appliquer sur une première entrée du régulateur (122) pour aire varier la tension d'alimentation fournie par celui-ci, ce qui permet de faire varier le gain de l'amplificateur tout en conservant un taux d'ondes stationnaires sensiblement constant, et des moyens de modulation (140—151) permettant à partir d'un signal numérique de commande de fournir sur une deuxième enrée du régulateur (122) un signal de référence modulé par tout ou rien en rapport avec ce signal numérique de commande pour couper la tension d'alimentation selon la modulation du signal de référence.

2. Amplificateur selon la revendication 1, ca ractérisé en ce que le circuit de commande comprend en outre des moyens (132—134) pour fournir au régulateur (122) la tension d'alimentation à réguler; ces moyens permettant en outre de couper cette tension sous la commande d'un signal de coupure.

3. Amplificateur selon l'une quelconque des revendications 1 et 2 caractérisé en ce qu'il comprend trois étages d'amplification hyperfréquence (101—103) munis chacun d'un transistor du type THC 9311-9312, et que le régulateur de tension (122) et le circuit de commande (123) permettent de faire varier la tension d'alimentation entre 7 volts et 3,5 volts, ce qui fait varier le gain de l'amplificateur etre 23 décibels et 13 décibels dans la bande de fréquence des 10 GHz.

## Patentansprüche

1. Mikrowellenverstärker mit mindestens einem FET (104) zur Mikrowellenverstärkung, der am Gitter ein zu verstärkendes Signal empfängt und am Drainpol das verstärkte Signal abgibt und der Anpassungs- (105) und Vorspannmittel (106, 107) besitzt, die mit dem Transistor ein vorangepaßtes und selbstvorgespanntes Bauteil (101) bilden, wobei der Verstärker außerdem einen Versorgungsspannungsregler (122) für den Drain-Quelle-Kreis des Transistors aufweist, dadurch gekennzeichnet, daß der Regler (122) den Drainpol des Transistors (101) mit einer variablen Regelspannung zu versorgen vermag und daß der Verstärker außerdem einen Steuerkreis (123) mit Verstärkungsmittel (136—139), mit dem ein analoges Steuersignal verstärkt und an einen ersten Eingang des Reglers (122) angelegt werden kann, um die von diesem gelieferte Versorgungsspannung zu verändern, so daß der Verstärkungsgrad des Verstärkers verändert werden kann und zugleich ein Anteil stehender Wellen im wesentlichen konstant gehalten werden kann, und andererseits Modulationsmittel (140—151) aufweist, die aufgrund eines digitalen Steuersignals an einen zweiten Eingang des Reglers (122) ein abhängig von diesem digitalen Steuersignal binärmoduliertes Bezugssignal zu liefern vermögen, um die Versorgungsspannung gemäß der Modulation des Bezugssignal abzuschalten.

2. Verstärker nach Anspruch 1, dadurch gekennzeichnet, daß der Steuerkreis außerdem Mittel (132—134) aufweist, die dem Regler (122) die zu regelnde Versorgungsspannung zuführen und die außerdem in der Lage sind, diese Spannung aufgrund der Steuerung duch ein Sperrsignal abzuschalten.

3. Verstärker nach einem beliebigen der Ansprüche 1 und 2, dadurch gekennzeichnet, daß er drei Mikrowellen-Verstärkungsstufen (101—103) aufweist, die je einen Transistor vom Typ THC 9311-9312 aufweisen, und daß der Spannungsregler (122) und der Steuerkreis (123) die Versorgungsspannung zwischen 7 Volt und 3,5 Volt zu variieren vermögen, wodurch der Verstärkungsgrad des Verstärkers zwischen 23 dB und 13 dB im 10 GHz-Frequenzband variiert wird.

## Claims

1. A microwave amplifier comprising at least one microwave amplification FET (104) the gate of which receives a signal to be amplified and the drain of which delivers the amplified signal, this transistor having matching (105) and biassing means (106, 107) which constitute with the transistor a prematched and self-biassed unitary component (101), this amplifier further comprising a supply voltage regulator (122) of the drain-source circuit of the transistor, characterized in that this regulator (122) is conceived to supply a variable regulated voltage and that the amplifier further comprises a control circuit (123) including amplification means (136—139) conceived to amplify an analog control signal and to apply this signal onto a first input of the regulator (122) in order to alter the supply voltage furnished by said regulator, thus altering the gain of the amplifier substantially without altering a rate of stationary waves, the control circuit further including modulation means (140—151) conceived to deliver a reference signal to a second input of the regulator (122) as a function of a digital control signal, this reference signal being modulated by all or nothing in relation to this digital control signal in order to cancel the supply voltage according to the modulation of the reference signal.

2. An amplifier according to claim 1, characterized in that the control circuit further comprises means (132—134) for furnishing the supply voltage to be regulated to the regulator (122), these means being further intended to cancel this voltage under the control of a cancellation signal.

3. An amplifier according to any one of claims 1 and 2, characterized in that comprises three microwave amplification stages (101—103), each one equipped with a transistor of the type THC 9311-9312, and that the voltage regulator (122) and the control circuit (123) are conceived to alter the supply voltage between 7 Volt and 3,5 Volt, thus altering the gain of the amplifier between 23 and 13 dB within the 10 GHz frequency band.

0 074 294